(19) Europäisches Patentamt
European Patent Office
Office européen des brevets

(11) **EP 2 381 472 A1**

(12) **DEMANDE DE BREVET EUROPEEN**

(43) Date de publication:
**26.10.2011 Bulletin 2011/43**

(51) Int Cl.:
**H01L 21/98** (2006.01)       **H01L 25/065** (2006.01)

(21) Numéro de dépôt: **11163545.4**

(22) Date de dépôt: **21.04.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **26.04.2010 FR 1053156**

(71) Demandeur: **Commissariat à l'Énergie Atomique et aux Énergies Alternatives**
**75015 Paris (FR)**

(72) Inventeurs:
• **Hilt, Thierry**
  **38530 Barraux (FR)**
• **Boutry, Hervé**
  **38470 Vinay (FR)**
• **Franiatte, Rémi**
  **38134 Saint Joseph de Rivière (FR)**
• **Moreau, Stéphane**
  **38340 Le Chevalon de Voreppe (FR)**

(74) Mandataire: **Colombo, Michel et al**
**Brevinnov**
**324, rue Garibaldi**
**69007 Lyon (FR)**

(54) **Procédé de fabrication d'un dispositif microélectronique et dispositif microélectronique ainsi fabriqué**

(57) L'invention concerne un procédé de fabrication d'un dispositif microélectronique sur un substrat comportant au moins un premier et un second composants électriques répartis, respectivement, dans des premier et second niveaux empilés l'un au-dessus de l'autre sur le substrat, ce procédé comprenant :
- la fabrication (102) d'au moins un premier et un deuxième bras de longueurs différentes, chacun de ces bras reliant mécaniquement directement un plot électrique à un point d'ancrage fixe respectif sur le substrat, et
- le plot électrique est fabriqué à l'intérieur du premier niveau puis déplacé (106), avant le raccordement électrique du second composant, vers une position de connexion dans laquelle une face supérieure du plot électrique et en contact avec l'intérieur du second niveau parallèlement au substrat.

Fig. 1

EP 2 381 472 A1

Fig. 3

Fig. 5

**Description**

L'invention concerne un procédé de fabrication d'un dispositif microélectronique sur un substrat et le dispositif microélectronique fabriqué.

Un dispositif microélectronique est un dispositif fabriqué par un procédé collectif de fabrication microélectronique. Ainsi, typiquement, un dispositif microélectronique est fabriqué par empilement et gravure, par exemple par photolithographie, de couches successives.

Des dispositifs microélectroniques comportent au moins un premier et un second composants électriques répartis, respectivement, dans des premier et second niveaux empilés l'un au-dessus de l'autre sur le substrat.

Un composant électrique est tout composant ayant besoin d'être raccordé électriquement à un autre composant électrique réalisé sur le même substrat dans un autre niveau. Par exemple, le composant électrique est une puce microélectronique, une piste conductrice ou une interconnexion électrique.

On désigne ici par puce microélectronique un morceau d'une plaquette semi-conductrice ou « wafer » en anglais. De préférence, ce morceau de plaquette comprend un ou des composants électroniques tels que des transistors, des condensateurs, des résistances, des inductances, des composants MOS (Metal Oxyde Semiconductor), MEMS (Microelectromechanical Systems) ou NEMS (Nanoelectromechanical systems) ou autres. Ces composants sont gravés ou déposés sur ce morceau de plaquette par des procédés collectifs de fabrication microélectronique tels que la lithographie, la gravure DRIE (Deep Reactive Ion Etching) ou autres.

Des procédés connus pour fabriquer un tel dispositif microélectronique comportent :

- la fabrication d'au moins un plot électrique dont la largeur et la longueur sont supérieures à son épaisseur, ce plot présentant une face supérieure, puis
- le raccordement électrique du second composant électrique sur ladite face supérieure pour relier électriquement ce composant électrique au premier composant électrique par l'intermédiaire de ce plot.

Par exemple, la demande de brevet WO 2009/147 148 divulgue un procédé de fabrication d'un dispositif microélectronique dans lequel une interconnexion électrolytique, qualifiée de « second type », traverse de part en part une couche d'enrobage latéral d'une puce microélectronique dans le premier niveau. Cette interconnexion est réalisée en cuivre et présente une section transversale importante, c'est-à-dire supérieure à 10 $\mu$m$^2$, pour avoir une face supérieure plane suffisamment large pour permettre d'établir de façon fiable le contact électrique avec le niveau supérieur. A cause de la section transversale importante, lorsque le dispositif microélectronique est soumis à une augmentation de température, le plot se dilate fortement. Cette dilatation peut détériorer le dispositif microélectronique.

Ainsi, il existe deux contraintes techniques contradictoires :

1. il faut que la section transversale de l'interconnexion soit importante pour avoir une face supérieure importante pour établir correctement le contact électrique avec le niveau supérieur, et
2. dans le même temps, il faut que la section transversale de l'interconnexion électrique soit petite pour réduire les problèmes liés à la dilatation et pour augmenter la densité d'interconnexions.

De plus, la section transversale ne peut pas être rendue plus petite que ce que permet l'état de l'art actuel de la lithographie et de l'électrolyse. Il existe donc une valeur limite pour le ratio entre la hauteur et la largeur de cette interconnexion. Enfin, la fabrication du plot électrique nécessite un grand nombre d'étapes dont, notamment, la mise en oeuvre d'une électrolyse. Ce procédé est donc assez complexe, long et donc onéreux.

L'invention vise à résoudre au moins l'un de ces inconvénients en proposant un autre mode de fabrication de ces dispositifs microélectroniques.

Elle a donc pour objet un procédé de fabrication dans lequel:

- le procédé comprend également la fabrication d'au moins un premier et un deuxième bras de longueurs différentes, chacun de ces bras reliant mécaniquement directement le plot électrique à un point d'ancrage fixe respectif sur le substrat, et
- le plot électrique est fabriqué à l'intérieur du premier niveau puis déplacé, avant le raccordement électrique du second composant, vers une position de connexion dans laquelle la face supérieure du plot électrique et en contact avec l'intérieur du second niveau parallèlement au substrat.

Dans la suite de cette description, on considère que la face supérieure est à l'intérieur d'un niveau même lorsqu'elle est simplement affleurante à ce niveau.

Le procédé ci-dessus présente de nombreux avantages. Le déplacement du plot électrique de sa position de fabrication à la position de connexion permet de fabriquer simplement un plot présentant une face supérieure de plus

de 10 μm2 sans pour autant qu'il soit relié au niveau inférieur par un pilier de section transversale importante. On limite donc les problèmes liés à la dilatation des plots électriques tout en conservant la possibilité d'établir un bon contact électrique avec la puce microélectronique d'un niveau supérieur. Par exemple, il reste possible d'implanter sur le plot électrique des micro-inserts ou d'y déposer une bille fusible pour établir le contact électrique avec la seconde puce. Un micro-insert est un dépôt d'un matériau permettant de réaliser un contact électrique par thermocompression. Par exemple, le matériau est du Nickel. Ceci est un avantage particulier de ce procédé par rapport à d'autres procédés où le contact électrique est assuré par la pointe d'une lame ressort qui vient en appui sur un méplat.

Ce procédé de fabrication est un procédé collectif de fabrication qui permet de fabriquer simultanément une multitude de dispositifs microélectroniques identiques sur un même substrat. La mise en oeuvre de ce procédé de fabrication nécessite moins d'étapes que les procédés existants. Par exemple, les pistes conductrices à l'intérieur du premier niveau et le plot électrique peuvent être réalisés lors d'une même étape. Il n'y a pas non plus d'étape d'électrolyse apriori.

Enfin, l'utilisation d'au moins deux bras de longueurs différentes permet de régler précisément la hauteur maximale à laquelle le plot électrique s'élève au-dessus du substrat dans la position de connexion.

Les modes de réalisation de ce procédé peuvent comporter une ou plusieurs des caractéristiques suivantes :

- ■ le procédé comprend également la fabrication d'au moins un troisième bras reliant mécaniquement le plot électrique à un autre point d'ancrage fixe sur le substrat, l'extrémité de ce troisième bras étant attaché au plot électrique en un point d'attache espacé des points d'attache des premier et deuxième bras, la longueur de ce troisième bras étant choisie pour maintenir la face supérieure du plot électrique parallèle au substrat dans la position de connexion ;
- ■ le procédé comprend la fabrication d'au moins quatre bras de même longueur, reliant chacun mécaniquement directement un point d'attache respectif de la face supérieure à un point d'ancrage fixe respectif sur le substrat, et d'au moins un bras de longueur différente reliant mécaniquement directement le plot électrique à un point d'ancrage respectif sur le substrat ;
- ■ le déplacement du plot électrique est actionné à l'aide d'une variation de température et/ou d'un apport extérieur d'énergie électrique ou magnétique;
- ■ après les étapes de fabrication et de déplacement du plot électrique, le procédé comprend le découpage du substrat pour isoler le dispositif microélectronique fabriqué des autres dispositifs microélectroniques fabriqués en même temps sur le même substrat;
- ■ le procédé comprend, avant l'empilement du second niveau et après le déplacement du plot, une étape d'enrobage du premier niveau avec un matériau d'enrobage pour former une base sur laquelle le second niveau est ensuite empilé et pour immobiliser le plot électrique dans sa position de connexion;
- ■ le procédé comprend, après le déplacement du plot et après l'empilement du second niveau, une étape d'enrobage du dispositif microélectronique avec un matériau d'enrobage pour immobiliser le plot électrique dans sa position de connexion;
- ■ après le déplacement du plot, le procédé comprend l'empilement du second composant électrique au moins en partie au-dessus du plot électrique de manière à raccorder le plot électrique à un contact électrique ménagé en vis-à-vis sur une face extérieure du second composant électrique;
- ■ la fabrication du plot électrique s'effectue en même temps que la fabrication de pistes conductrices et/ou de plots conducteurs du premier niveau sur le substrat;
- ■ le premier et/ou le second composants électriques est une puce microélectronique.

Ces modes de réalisation du procédé présentent en outre les avantages suivants :

- l'utilisation d'au moins un troisième bras permet de régler la planéité et le parallélisme du plot électrique dans la position de connexion ;
- l'utilisation d'au moins cinq bras permet de positionner le plot électrique à la hauteur souhaitée tout en le maintenant parallèle au substrat ;
- l'utilisation d'un apport extérieur d'énergie ou d'une variation de température permet de déclencher au moment souhaité le déplacement du plot électrique ;
- l'étape de découpage permet la fabrication collective de plusieurs dispositifs microélectroniques sur un même substrat ;
- l'enrobage du premier niveau avant l'empilement du second niveau permet de constituer une base rigide sur laquelle le second composant électrique peut facilement et précisément être positionné sans que des creux ou des pivots de guidage soient prévus entre les premier et second niveaux ;
- l'enrobage de plusieurs niveaux en même temps permet un gain de temps et simplifie le procédé;
- l'empilement du second composant électrique au-dessus du plot électrique permet de limiter le nombre de pistes conductrices à graver dans le second niveau ;

- la fabrication du plot électrique en même temps que la fabrication des pistes conductrices du premier niveau simplifie le procédé de fabrication.

L'invention a également pour objet un dispositif microélectronique comportant

- un substrat,
- au moins un premier et un second composants électriques répartis, respectivement, dans des premier et second niveaux empilés l'un au-dessus de l'autre sur le substrat,
- au moins un plot électrique dont la largeur et la longueur sont supérieures à son épaisseur, par l'intermédiaire duquel les premier et second composants électriques sont électriquement reliés entre eux, ce plot électrique présentant une face supérieure,
- au moins un premier et un deuxième bras de longueurs différentes, chacun de ces bras reliant mécaniquement directement le plot électrique à un point d'ancrage fixe respectif sur le substrat.

Les modes de réalisation de ce dispositif peuvent comporter une ou plusieurs des caractéristiques suivantes :

■ le dispositif microélectronique comporte un dépôt de matériau fusible ou thermocompressible pour réaliser le raccordement électrique entre le second composant électrique et le plot.

L'invention sera mieux comprise à la lecture de la description qui va suivre, donnée uniquement à titre d'exemple non limitatif et faite en se référant aux dessins sur lesquels :

- la figure 1 est une illustration schématique d'un dispositif microélectronique comportant des composants électriques répartis dans deux niveaux empilés,
- la figure 2 est une illustration schématique en vue de dessus d'une interconnexion électrique entre deux des composants du dispositif de la figure 1,
- les figures 3 et 4 sont des illustrations schématiques de l'interconnexion de la figure 2 dans une position de fabrication, respectivement, en vue de côté et en vue de dessus ;
- la figure 5 est une illustration schématique de l'interconnexion de la figure 2 dans une position de connexion ;
- la figure 6 est un graphe illustrant le calcul de la hauteur h à laquelle s'élève l'interconnexion de la figure 2 dans la position de connexion ;
- la figure 7 est un organigramme d'un procédé de fabrication du dispositif de la figure 1 ;
- les figures 8 à 24 sont des illustrations schématiques et en vue de côté de différentes étapes de fabrication du procédé de la figure 7 ;
- la figure 25 est une illustration schématique en vue de côté d'un autre mode de réalisation de l'interconnexion de la figure 2 ;
- la figure 26 est une illustration en vue de dessus de l'interconnexion de la figure 25 ;
- la figure 27 est une illustration schématique d'un autre dispositif microélectronique susceptible d'être fabriqué à l'aide du procédé de la figure 7 ;
- la figure 28 est également un autre mode de réalisation d'un dispositif microélectronique réalisé en utilisant l'enseignement du procédé de la figure 7 ;
- la figure 29 est une illustration en vue de dessus d'une interconnexion particulièrement mise en oeuvre dans le dispositif de la figure 28;
- la figure 30 est une illustration schématique en vue de dessus d'un autre exemple de réalisation de l'interconnexion électrique.

Dans ces figures, les mêmes références sont utilisées pour désigner les mêmes éléments.

Dans la suite de cette description, les caractéristiques et fonctions bien connues de l'homme du métier ne sont pas décrites en détail.

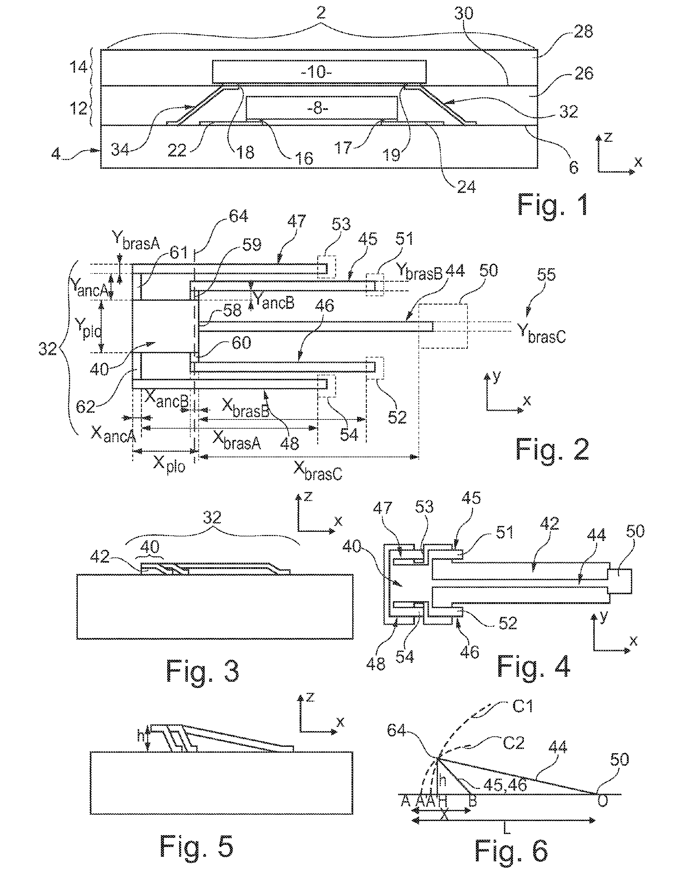

La figure 1 représente un dispositif microélectronique 2. Ce dispositif 2 comporte un substrat 4 sur lequel sont empilés plusieurs composants électriques. Ici, le dispositif 2 est décrit dans le cas particulier où ces composants électriques sont des puces microélectroniques. Typiquement, la plus grande dimension d'une puce microélectronique est inférieure à 5 mm.

Le substrat 4 est une portion d'une galette semi-conductrice ou « wafer » obtenue après une étape de découpage. Ce substrat est un substrat plan représenté ici à l'horizontal. L'horizontal est repéré par deux directions orthogonales X et Y dont seule la direction X est visible sur la figure 1. Dans cette figure et dans les figures suivantes, la direction Z représente la direction verticale.

Le substrat 4 présente une face supérieure plane 6 sur laquelle sont déposées ou gravées des pistes conductrices pour raccorder les puces microélectroniques entre elles et aux différents composants électroniques déposés sur ou intégrés au substrat 4. Les pistes conductrices s'étendent uniquement à l'intérieur d'un même niveau. Typiquement, des pistes d'alimentation des différentes puces microélectroniques superposées sont réalisées dans la face supérieure 6.

Pour simplifier la figure 1, seules deux puces microélectroniques 8 et 10 réparties, respectivement, dans des niveaux 12 et 14 sont représentées. Le niveau 14 est empilé sur le niveau 12. Chaque niveau présente une épaisseur constante et s'étend parallèlement à la face 6.

Ces puces 8 et 10 comprennent des contacts électriques sur leurs faces inférieures tournées vers la face 6. Par exemple, les puces 8 et 10 comportent, respectivement, des contacts électriques 16, 17 et 18, 19. Les contacts 16 et 17 sont raccordés à des pistes conductrices, respectivement, 22 et 24 déposés ou gravées sur la face 6. Par exemple, la connexion électrique des contacts 16 et 17 sur les pistes 22 et 24 se fait à l'aide de micro-inserts ou de billes fusibles.

Chaque puce 8, 10 est noyée dans sa propre couche d'enrobage, respectivement, 26 et 28. Ces couches d'enrobage s'étendent latéralement sur l'ensemble de la périphérie de chacune des puces. Ces couches d'enrobage permettent de protéger et de fixer les puces sur le substrat de façon définitive. Par exemple, elles sont réalisées en polymère telle qu'une résine de type époxy. Ici, la démarcation entre les couches d'enrobage 26 et 28 correspond à la limite entre les niveaux 12 et 14.

Le dispositif 2 comprend également des interconnexions électriques pour raccorder électriquement les puces 8 et 10 entre elles. Ici, deux interconnexions 32 et 34 sont représentées. Par exemple, chacune de ces interconnexions 32, 34 connecte électriquement la puce 10 à des pistes conductrices du substrat 4 électriquement raccordée à la puce 8.

Ces interconnexions traversent de part en part la couche d'enrobage 26. Une telle technologie d'interconnexion par l'extérieur de la puce est connue sous le terme anglais de « chip in polymer ».

Ici, les interconnexions 32 et 34 sont identiques et seule l'interconnexion 32 est décrite ci-dessous plus en détail.

Les figures 2 à 5 représentent plus en détail un mode particulier de réalisation de l'interconnexion 32. L'interconnexion 32 comporte un plot électrique mobile 40. Ce plot 40 est destiné à venir se placer sous la puce 10 en vis-à-vis d'un des contacts électriques, ici le contact 19, de cette puce pour raccorder électriquement la puce 10 au substrat 4. La largeur et la longueur du plot 40 sont très supérieures à son épaisseur. Par « très supérieur », on désigne le fait que la largeur et la longueur sont au moins 5, 10 ou 50 fois plus grand que l'épaisseur. La face supérieure du plot 40 est plane et présente une surface d'au moins 10 $\mu$m$^2$ et de préférence d'au moins 100 $\mu$m$^2$ de manière à permettre l'établissement d'une connexion électrique robuste et fiable avec la puce 10.

Le plot 40 est déplaçable entre une position de fabrication représentée sur les figures 3 et 4 et une position de connexion représentée sur les figures 1 et 5.

Dans la position de fabrication, le plot 40 est uniquement situé à l'intérieur du niveau 12. Par exemple, dans la position de fabrication, le plot 40 est séparé de la face 6 du substrat uniquement par l'épaisseur d'une couche sacrificielle 42 (figure 3). Par exemple, l'épaisseur de la couche 42 est inférieure à 10 $\mu$m.

Dans la position de connexion, le plot 40 s'élève au-dessus du substrat 4. Ici, la distance qui sépare le plot 40 de la face 6 du substrat dans la position de connexion est notée h (figure 5). Cette hauteur h est supérieure ou égale à l'épaisseur du niveau 12. Typiquement, la hauteur h est supérieure à 20 $\mu$m ou à 100 $\mu$m.

Des moyens d'actionnement du déplacement du plot 40 entre ces positions de fabrication et de connexion sont prévus dans le dispositif 2. Par exemple, ici, l'interconnexion 32 comporte également cinq bras 44 à 48 rectiligne mécaniquement raccordés, à une extrémité, au plot 40 et, à l'autre extrémité, à un point d'encrage respectif fixe sur la face 6. Sur la figure 2, les points d'ancrage des bras 44 à 48 sont représentés par des carrés en pointillés, respectivement, 50 à 54. Ces points d'ancrage 50 à 54 sont situés à des emplacements différents sur la face 6.

Les bras 44 à 48 s'étendent parallèlement à un même plan vertical 55 dont seule l'intersection avec la face horizontale 6 est représentée sur la figure 2. Ce plan 55 est perpendiculaire à la face 6.

Ici, ce plan 55 est également un plan de symétrie pour le plot 40 et les bras 44 à 48. Le plot 40, le bras 44 et le point d'ancrage 50 s'étendent de part et d'autre du plan 55.

Dans la position de fabrication (figure 3) les bras 44 à 48 s'étendent également essentiellement parallèlement à la face 6.

Ici, dans la position de connexion, les bras 44 à 48 sont inclinés par rapport à la verticale et l'horizontal. Par exemple, l'angle entre la direction dans laquelle s'étend le bras et la face 6 est compris entre 5° et 85°.

Chaque bras 44 à 48 présente une section transversale dont la surface est, à titre d'exemple, inférieure à quelques $\mu$m$^2$ ou à quelques centaines de $\mu$m$^2$.

L'extrémité de chaque bras opposée au point d'ancrage est fixée au plot 40 par un point d'attache respectif 58 à 62.

Ici, les points d'attache 58 à 60 des bras 44 à 46 sont alignés sur un même axe 64 perpendiculaire au plan 55. Cet alignement des points d'attache 58 à 60 est ici utilisé pour régler précisément la hauteur h. Le schéma de la figure 6 permet de comprendre comment les bras 44 à 46 agissent pour fixer la hauteur h atteinte dans la position de connexion. L'axe 64 est situé sur l'arc de cercle C1 dont le centre O est déterminé par la position du point d'ancrage 50. Dans le même temps, l'axe 64 est situé sur l'arc de cercle C2 dont le centre B est déterminée par la position des points d'ancrage 51 et 52. Dans le cas où la longueur du bras 44 est strictement supérieure à la longueur des bras 45 et 46, la hauteur h à laquelle s'élève le plot 40 dans la position de connexion est alors donnée par la relation suivante :

$$h = \left[ \left(1 - k\varDelta T\right)^2 \left(\frac{L^2 + y^2}{2}\right) - \left(\frac{\left(1 - k\varDelta T\right)^2 (L + y)}{2}\right)^2 - \left(\frac{L - y}{2}\right)^2 \right]^{1/2}$$

où :

- k est le coefficient de dilatation thermique du matériau utilisé pour réaliser les bras,
- $\varDelta T$ est l'écart en °C entre les températures dans la position de fabrication et dans la position de connexion,
- L est la longueur du bras 44 à la température T1 de fabrication de l'interconnexion 32,
- y est la longueur des bras 45, 46 à la température T1.

En effet, lorsqu'après sa fabrication, l'interconnexion 32 est refroidie, étant donné que le bras 44 est plus long que les bras 45 et 46, celui se rétracte plus. Cela provoque une traction sur le point d'attache 58 qui conduit à soulever le plot 40 grâce au mouvement des bras 45 et 46 qui font alors leviers jusqu'à atteindre la hauteur h. Ici, le bras ou les bras qui tirent le plot 40 sont qualifiés de « bras d'actionnement » tandis que les autres bras qui travaillent en compression sont qualifiés de « bras levier ». Pour que ce moyen d'actionnement du déplacement du plot 40 fonctionne, il faut que les centres O et B ne soient pas confondus. Ceci est obtenu en décalant la position des points d'ancrage 51 et 52 le long de l'axe X par rapport à la position du point d'ancrage 50 du bras 44.

Par ailleurs, la distance entre les centres O et B doit être suffisante pour permettre l'exercice d'une force de traction capable de soulever le plot 40. Cette distance doit cependant rester assez petit pour éviter que le bras 44 se déforme par flambage. Par exemple, cette distance est déterminée expérimentalement avec un logiciel de simulation en tenant compte de la hauteur h que l'on souhaite atteindre dans la position de connexion.

Ici, le plot 40 est rectangulaire. Les points d'attache 59 à 62 sont disposés à chaque angle du plot 40 pour maintenir la face supérieure du plot 40 parallèle à la face 6 dans la position de connexion. Cette disposition des points d'attache 59 à 62 permet de contrôler la planéité du plot 40 dans la position de connexion. De préférence, cette planéité doit être contrôlée pour que la distance entre le point le plus haut et le point le plus bas de la face supérieure du plot 40 reste inférieure à 5 $\mu$m et, de préférence, inférieure à 1 $\mu$m dans la position de connexion. La longueur des bras 45 à 48 est déterminée pour contrôler la planéité et le parallélisme de la face supérieure du plot 40 par rapport à la face 6 du substrat. Dans la position de connexion, la face supérieure du plot 40 est parallèle à la face 6.

La longueur du bras 44 ne doit pas être égale à la longueur des autres bras. La longueur des bras 45 et 47 ne sont pas forcément les mêmes.

Par exemple, la longueur des bras 44 à 48 est ici déterminée par expérimentation. Par exemple pour cela, un modèle numérique de l'interconnexion 32 et de ces déformations est simulé.

A titre d'illustration, les différentes dimensions de l'interconnexion 32 sont comprises dans les plages définies dans le tableau suivant :

| Nom du paramètre sur la figure 2 | Min ($\mu$m) | Max ($\mu$m) |
|---|---|---|
| Xplot | 100 | 200 |
| Yplot | 100 | 200 |
| XbrasC | 200 | 2000 |
| YbrasC | 30 | 200 |
| XbrasA | 200 | 2000 |
| YbrasA | 30 | 50 |
| XancA | 10 | 200 |
| YancA | 10 | 30 |
| XbrasB | 200 | 2000 |
| YbrasB | 30 | 50 |

(suite)

| Nom du paramètre sur la figure 2 | Min ($\mu$m) | Max ($\mu$m) |
|---|---|---|
| XancB | 10 | 200 |
| YancB | 10 | 30 |

Ici, les bras 44 à 48, les points d'ancrage 50 à 54 et le plot 40 sont réalisés dans un même matériau électriquement conducteur. Ainsi, au moins un de ces bras remplit le rôle de conducteur électrique connectant électriquement le plot 40 aux pistes du substrat 4. Par exemple, le matériau utilisé est du cuivre. Plus précisément, l'interconnexion 32 est réalisée dans une seule et même couche de ce matériau électriquement conducteur.

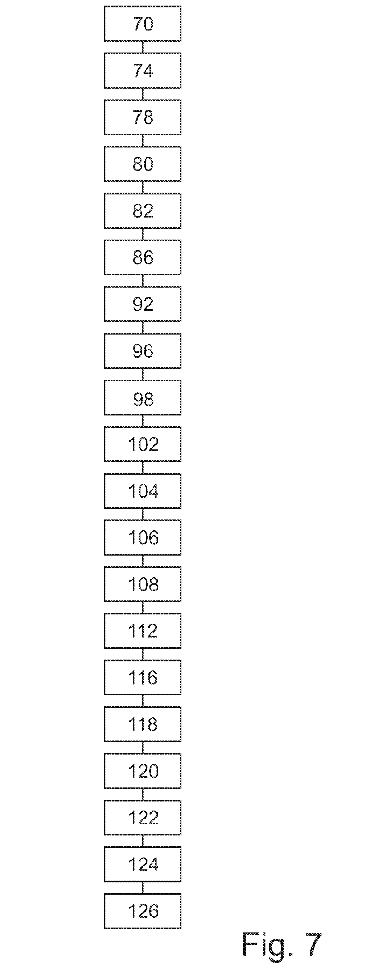

La figure 7 représente un exemple de procédé de fabrication du dispositif 2.

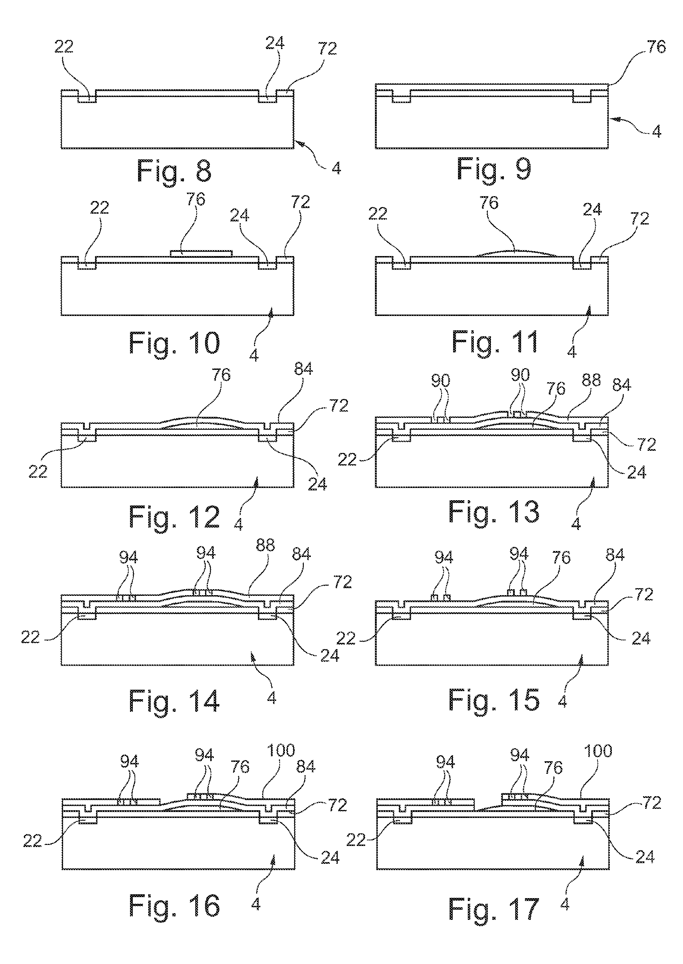

Initialement, lors d'une étape 70, une galette ou « wafer » en anglais est fournie. Sur cette galette, plusieurs dispositifs 2 sont simultanément fabriqués. Ainsi, les pistes conductrices de plusieurs dispositifs microélectroniques sont réalisées. Cette galette peut également intégrer des composants électroniques. Pour simplifier les figures 8 à 28 :

- seule une section transversale de cette galette correspondant à un seul dispositif microélectronique est illustrée aux différents stades de fabrication,
- seule la fabrication de l'interconnexion 32 est illustrée, et
- les bras 45 à 48 de l'interconnexion 32 ont été omis.

La figure 8 représente la section transversale de la galette correspondant au dispositif 2 au tout début de sa fabrication. Cette galette forme le substrat 4 sur lequel sont déposées ou gravées les pistes conductrices 22 et 24. Une couche diélectrique 72 recouvre l'ensemble de la face 6 du substrat 4 à l'exception des pistes conductrices 22 et 24.

Ensuite, lors d'une étape 74 (figure 9), on dépose sur le substrat 4 une couche sacrificielle 76. Par exemple, cette couche 76 est une résine.

Lors d'une étape 78 (figure 10), la couche sacrificielle 76 est structurée, par exemple, par lithographie pour laisser subsister la couche sacrificielle uniquement à l'aplomb du plot 40 et des bras 44 à 48.

Ensuite, lors d'une étape 80 (figure 11), la couche sacrificielle 76 est recuite de manière à obtenir une forme bombée.

Lors d'une étape 82 (figure 12), une couche métallique 84 est déposée sur l'ensemble de la face supérieure 6 du substrat 4. Ce dépôt se fait par exemple à une température T1 de dépôt supérieure ou égale à 200° C.

Lors d'une étape 86 (figure 13), une couche 88 de résine photosensible est déposée sur la couche métallique 84 puis structurée par photolithographie pour ménager des logements 90 où doivent être réalisés des micro-inserts métalliques.

Lors d'une étape 92 (figure 14), un matériau métallique conducteur 94 est déposé dans les logements 90 préparés lors de l'étape 86. Ces dépôts métalliques forment alors des micro-inserts 94 directement déposés sur la couche conductrice 84.

Ensuite, lors d'une étape 96 (figure 15), la résine photosensible 88 est éliminée de manière à dégager les micro-inserts 94.

Lors d'une étape 98 (figure 16), une nouvelle couche 100 de résine photosensible est déposée sur le substrat 4 puis structurée, par exemple par photolithographie, de manière à délimiter les emplacements où les différentes pistes conductrices du substrat 4 et les interconnexions 32, 34 doivent être réalisées.

Lors d'une étape 102 (figure 17), la même couche 84 est gravée pour former les pistes conductrices du niveau 12 ainsi que les interconnexions 32 et 34. Ces pistes conductrices servent, par exemple, à raccorder au moins l'un des points d'ancrage des bras 50 à 54 aux pistes 22 et 24. Ces pistes conductrices sont fixes et ne sont pas amenées à se déplacer ultérieurement.

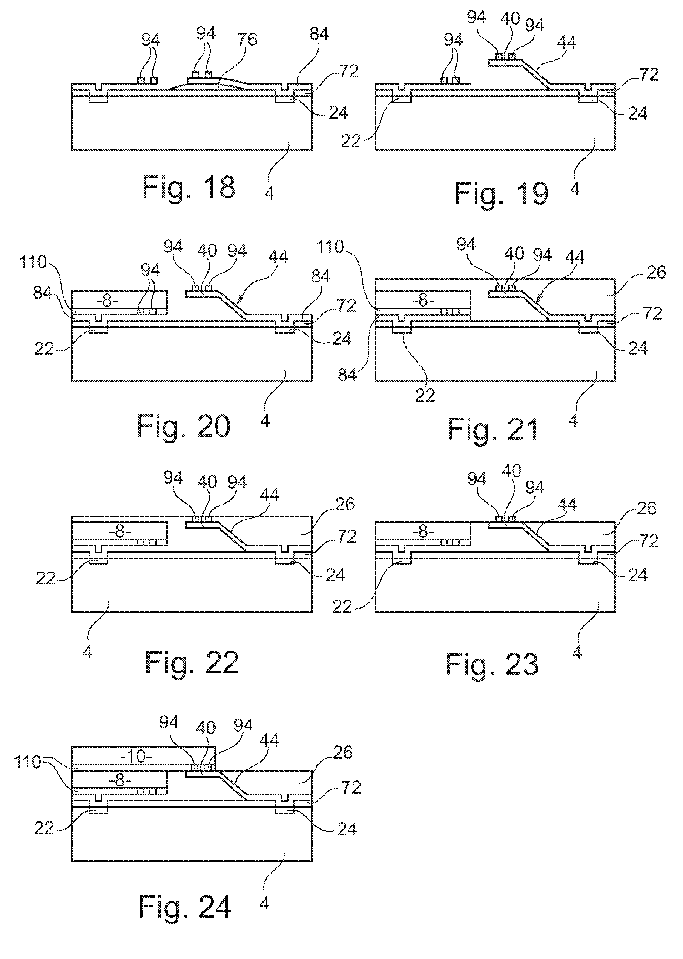

Lors d'une étape 104 (figure 18) la couche 100 de résine photosensible est retirée.

Lors d'une étape 106 (figure 19), la couche sacrificielle 76 est également éliminée et la température est abaissée à une température T2. Par exemple, la température T2 est inférieure ou égale à 100°C. Ici, la température T2 est voisine de 80° C. L'élimination de la couche sacrificielle 76 libère le plot 40 et les bras 44 à 48. L'abaissement de la température actionne le déplacement du plot 40 de sa position de fabrication vers sa position de connexion.

Lors d'une étape 108 (figure 20), on procède à une hybridation de la puce 8 dans le premier niveau. Lors de cette étape, une couche de colle 110 est déposée à l'emplacement où doit être collée la puce 8. La puce 8 est ensuite déposée sur cette couche de colle et mise en contact électrique avec la couche 84 et les pistes 22, 24 par l'intermédiaire des micro-inserts 94.

Ensuite, lors d'une étape 112 (figure 21), on procède à un enrobage latéral de la puce 8. Cet enrobage consiste à répartir du polymère tout autour de la puce 8 et également, ici, sur sa face supérieure. Le plot 40 ainsi que les micro-inserts 94 implantés sur ce plot sont entièrement noyés dans la couche d'enrobage 26. Après sont dépôt, la couche 26 durcit est fixe de façon définitive la puce 8 sur le substrat 4. Le durcissement de la couche 26 immobilise également l'interconnexion 32 dans sa position de connexion.

Lors d'une étape 116 (figure 22), la couche d'enrobage 26 est amincie et planérisée par usinage mécanique. Par exemple, pour cela on utilise le procédé CMP (Chemical Mechanical Polishing). Cet amincissement permet de rendre les micro-inserts 94 implantés sur le plot 40 affleurants au niveau de la face supérieure de la couche d'enrobage 26.

Ensuite, lors d'une étape 118 (figure 23), on procède à la gravure de la couche 26 d'enrobage sur l'épaisseur des micro-inserts 94 de manière à ce que la face supérieure du plot 40 soit maintenant affleurante.

Lors d'une étape 120 (figure 24), on procède à l'hybridation de la deuxième puce 10. L'hybridation de la deuxième puce 10 est par exemple réalisée comme décrit en regard de l'étape 108. La puce 10 est empilée au-dessus du plot 40 de manière à ce que son contact électrique 19 (non représenté sur la figure 24) soit en vis-à-vis du plot 40. Le plot 40 est alors électriquement raccordé à la puce 110 par l'intermédiaire des micro-inserts 94.

Lors d'une étape 122 on procède à l'enrobage latéral de la puce 10.

Une fois cet enrobage réalisé, lors d'une étape 124, les différents dispositifs microélectroniques identiques fabriqués sur la même galette sont séparés les uns des autres lors d'une étape 124 de découpage.

Lors d'une étape 126, après cette étape de découpage, les différents dispositifs microélectroniques comportant des puces empilées les unes sur les autres sont par exemple incorporés dans des boîtiers équipés de pattes ou de plots de connexion permettant de les raccorder sur une carte électronique ou un circuit électrique.

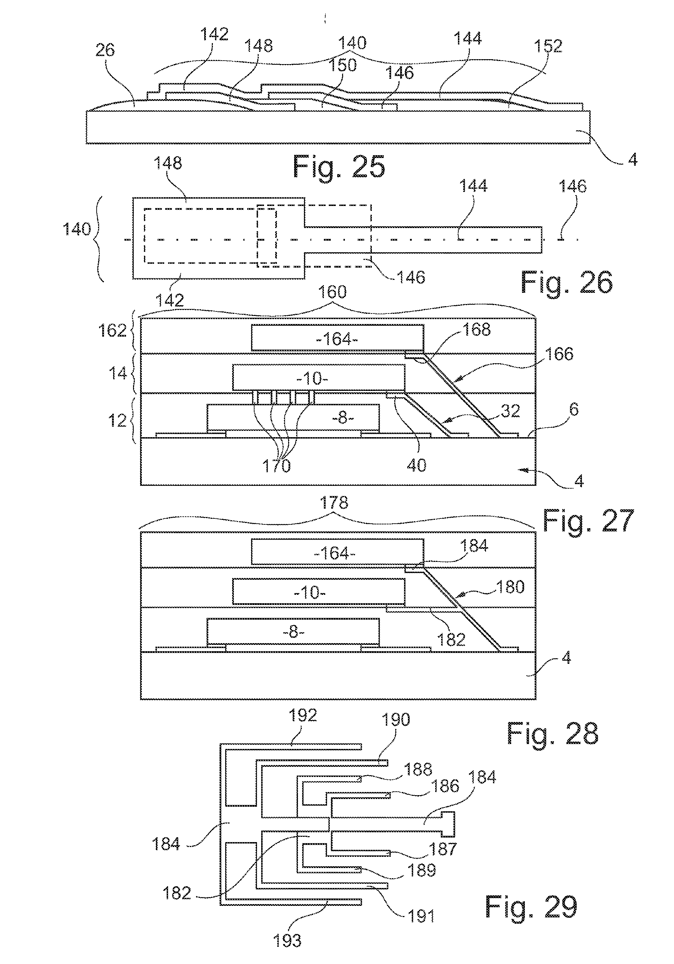

Les figures 25 et 26 représentent un autre mode de réalisation possible d'une interconnexion 140 susceptible d'être utilisée dans le dispositif 2 à la place de l'interconnexion 32 ou 34. Cette interconnexion 140 se distingue de l'interconnexion 32 par le fait que seuls trois bras sont utilisés à la place des cinq bras précédemment décrits. Elle comporte :

- un plot mobile 142 similaire au plot 40, et
- un bras 144, par exemple identique au bras 44,qui s'étend dans un plan vertical 146 de symétrie.

Dans ce mode de réalisation, les bras 45 et 46 sont remplacés par un seul et même bras 146. Ce bras 146 est par exemple obtenu en rejoignant les bras 45 et 46 pour ne former qu'un seul plan s'étendant sous le bras 144. Les bras 47 et 48 sont également remplacés par un seul bras 148 obtenu, par exemple, en rejoignant les bras 47 et 48 de l'interconnexion 32 pour ne former qu'un seul plan s'étendant sous le bras 146.

Une telle interconnexion 140 est réalisée en utilisant plusieurs blocs 149, 150 et 152 de couche sacrificielle situés à l'aplomb, respectivement, du plot 142, du bras 146 et du bras 144.

Lorsque les blocs sacrificiels 149, 150 et 152 sont éliminés, ils libèrent l'interconnexion 140 et le plot 142 peut alors être déplacé de sa position de fabrication représentée sur la figure 25 vers une position de connexion.

La figure 27 représente un autre mode de réalisation d'un dispositif microélectronique 160. Ce dispositif 160 est similaire au dispositif 2 à l'exception qu'il comporte en plus des niveaux 12 et 14 un troisième niveau 162 empilé au-dessus du niveau 14 et dans lequel est logé une puce microélectronique 164.

La puce 164 est électriquement raccordée aux puces 8 et 10 par l'intermédiaire d'une interconnexion 166 qui la relie électriquement directement à la face supérieure 6 du substrat 4. Cette interconnexion 166 est réalisée de façon similaire à l'interconnexion 32 à l'exception du fait que les bras sont dimensionnés pour élever un plot électrique 168 non pas à la même hauteur que le plot 40 mais à une hauteur nettement supérieure de manière à ce que ce plot 168 soit situé à l'intérieur du niveau 162. Par exemple, dans la position de connexion, le plot 168 s'élève à une hauteur $h_1$ supérieure ou égale au double de la hauteur h.

Eventuellement, des micro-inserts sont réalisés entre la face supérieure d'une des puces et la face inférieure directement en vis-à-vis de la puce du niveau supérieur pour connecter directement les contacts électriques de ces faces. A titre d'illustration, sur la figure 27 la face supérieure de la puce 8 est connectée à la face inférieure de la puce 10 par des micro-inserts 170 qui s'étendent uniquement verticalement.

Les figures 28 et 29 représentent un autre mode de réalisation possible d'une interconnexion 180 susceptible de raccorder électriquement les puces 10 et 164 de la figure 27.

A cet effet, l'interconnexion 170 comprend deux plots 182 et 184, similaires au plot 40, raccordés au substrat 4 par l'intermédiaire d'un bras commun 184 et de bras leviers respectifs 186 à 189 et 190 à 193.

Le bras 184 remplit la même fonction que le bras 44. Par exemple le bras 184 est identique au bras 44 à l'exception du fait qu'il s'étend d'un point d'ancrage jusqu'au plot 184 en passant par le plot 182.

Les bras 186 à 189 et 190 à 193 remplissent les mêmes fonctions que les bras 45 à 48 vis-à-vis, respectivement, des plots 182 et 184.

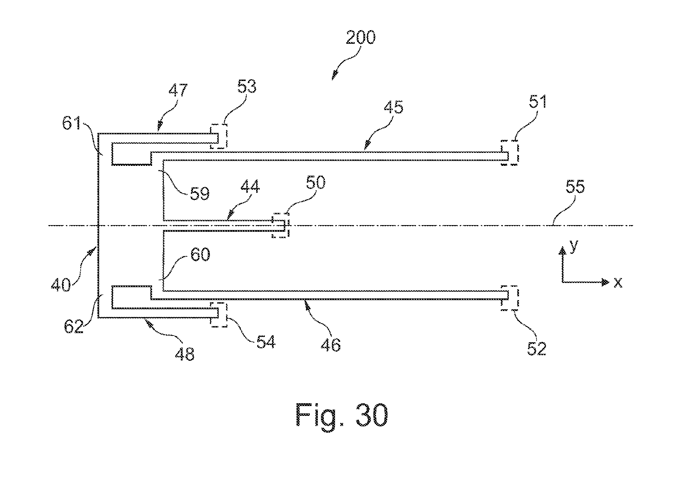

La figure 30 représente une interconnexion 200 identique à l'interconnexion 32 sauf que les longueurs des bras dans la direction X ont été modifiées. Plus précisément, dans ce mode de réalisation la longueur des bras 44, 47 et 48 est strictement inférieure à la longueur des bras 45 et 46. De préférence, la longueur des bras 44, 47 et 48 est au moins deux, trois ou quatre fois inférieure à la longueur des bras 45 et 46. Par exemple, la longueur du bras 44 est égale à la longueur des bras 47 et 48 à plus ou moins 30% près. Ici, les longueurs des bras 44, 47 et 48 sont égales. Dans ce mode de réalisation, les bras 45 et 46 sont les bras d'actionnement tandis que les bras 44, 47 et 48 sont les bras leviers.

De nombreux autres modes de réalisation sont possibles. Par exemple, les micro-inserts 94 peuvent être remplacés par tout moyen susceptible de raccorder un contact d'une puce microélectronique à un plot électrique en vis-à-vis de ce contact. Par exemple, une bille fusible peut être utilisée à la place des micro-inserts.

Les pistes conductrices peuvent être multicouches avec une sous-couche d'accroche.

D'autres moyens d'actionnement du déplacement du plot mobile peuvent être utilisés. Par exemple, le plot électrique peut être mécaniquement solidaire d'un bras d'actionnement formé lui-même par une superposition de plusieurs couches réalisées dans des matériaux ayant des coefficients de dilatation différents. Dans ce cas, le bras d'actionnement fonctionne comme un bilame.

Le ou les bras d'actionnement peuvent également être réalisés en matériau piézo-électrique de manière à déplacer le plot mobile de la position de fabrication à la position de connexion. Dans ce cas, des pistes électriques pouvant faire circuler le courant dans ces bras piézoélectriques sont prévues notamment sur le substrat 4.

Le plot mobile peut également être déplacé en utilisant des forces électrostatiques. Par exemple, à cet effet, le plot ou un bras est équipé d'une plaque conductrice chargée avec une certaine polarité et une plaque de polarité opposée est formée, par exemple sur le substrat, pour repousser la plaque solidaire du plot mobile.

Les moyens d'actionnement peuvent également être des moyens magnétiques. Par exemple, le plot ou l'un des bras est réalisé dans un matériau aimanté ou aimantable. En face de ce bras ou plot en matériau aimanté, une bobine ou un aimant commandable est créé de manière à repousser ou au contraire à attirer le plot électrique. Typiquement, cette bobine sera formée sur la face 6 du substrat 4.

Dans un autre mode de réalisation, les moyens d'actionnement sont des matériaux à mémoire de forme. Dans ce cas, le déplacement du plot mobile entre ses positions de fabrication et d'assemblage est par exemple déclenché par le passage d'un courant électrique.

L'interconnexion décrite ici peut également être utilisée pour raccorder électriquement une puce microélectronique située à un niveau N à une puce microélectronique située au niveau inférieur N-1, le niveau N-1 étant strictement supérieur à 1. Cela revient à réaliser l'interconnexion sur un substrat contenant déjà une puce microélectronique ou un empilement de puces microélectroniques. Par exemple, une interconnexion similaire à l'interconnexion 32 peut être fabriquée sur le niveau 12 pour connecter directement la puce 10 à la puce 164 de la figure 27 sans passer par des pistes conductrices du niveau 12, c'est-à-dire celles gravées sur le substrat 4. Le procédé pour fabriquer cette interconnexion est, par exemple, le même que celui décrit en regard de la figure 7 sauf que le substrat sur lequel est réalisé l'interconnexion comporte déjà le substrat 4 et le niveau 12.

Le plot 40 n'est pas nécessairement rectangulaire. Par exemple, il peut être circulaire ou avoir d'autres formes. Dans ces derniers cas, la largeur et la longueur du plot correspondent aux deux dimensions les plus caractéristiques de la face supérieure du plot. Dans le cas d'une face circulaire, la largeur et la longueur sont égales au diamètre.

Les bras de levier ou d'actionnement ne sont pas nécessairement rectilignes. Par exemple, un bras peut avoir la forme d'une spirale.

Le procédé décrit ici permet d'empiler et de raccorder électriquement deux ou plusieurs niveaux de composants électriques et ainsi former un dispositif microélectronique de type 3D à faible coût.

L'enrobage des composants électriques de chaque niveau peut également être réalisé après avoir déplacé les plots vers leur position de connexion et après avoir connecté les composants électriques des niveaux supérieurs sur ces plots. Ainsi, une seule étape d'enrobage est mise en oeuvre pour enrober en même temps plusieurs niveaux.

## Revendications

**1.** Procédé de fabrication d'un dispositif microélectronique sur un substrat comportant au moins un premier et un second composants électriques répartis, respectivement, dans des premier et second niveaux empilés l'un au-dessus de l'autre sur le substrat, ce procédé comprenant :

- la fabrication (102) d'au moins un plot électrique dont la largeur et la longueur sont supérieures à son épaisseur, ce plot présentant une face supérieure, puis
- le raccordement électrique (120) du second composant électrique sur ladite face supérieure pour relier électriquement ce composant électrique au premier composant électrique par l'intermédiaire de ce plot

**caractérisé en ce que** :

- le procédé comprend également la fabrication (102) d'au moins un premier et un deuxième bras de longueurs différentes, chacun de ces bras reliant mécaniquement directement le plot électrique à un point d'ancrage fixe respectif sur le substrat, et
- le plot électrique est fabriqué à l'intérieur du premier niveau puis déplacé (106), avant le raccordement électrique du second composant, vers une position de connexion dans laquelle la face supérieure du plot électrique et en contact avec l'intérieur du second niveau parallèlement au substrat.

2. Procédé selon la revendication 1, dans lequel au moins un des bras est réalisé dans un matériau électriquement conducteur de manière à ce que ce bras remplisse le rôle de conducteur électrique connectant électriquement le plot au premier composant électrique.

3. Procédé selon l'une quelconque des revendications précédentes, dans lequel le procédé comprend également la fabrication (102) d'au moins un troisième bras reliant mécaniquement le plot électrique à un autre point d'ancrage fixe sur le substrat, l'extrémité de ce troisième bras étant attaché au plot électrique en un point d'attache espacé des points d'attache des premier et deuxième bras, la longueur de ce troisième bras étant choisie pour maintenir la face supérieure du plot électrique parallèle au substrat dans la position de connexion.

4. Procédé selon la revendication 3, dans lequel le procédé comprend la fabrication (102) :

- d'au moins quatre bras de même longueur, reliant chacun mécaniquement directement un point d'attache respectif de la face supérieure à un point d'ancrage fixe respectif sur le substrat, et
- d'au moins un bras de longueur différente reliant mécaniquement directement le plot électrique à un point d'ancrage respectif sur le substrat.

5. Procédé selon l'une quelconque des revendications précédentes, dans lequel le déplacement du plot électrique est actionné à l'aide d'une variation de température et/ou d'un apport extérieur d'énergie électrique ou magnétique.

6. Procédé selon l'une quelconque des revendications précédentes, dans lequel, après les étapes de fabrication et de déplacement du plot électrique, le procédé comprend le découpage (124) du substrat pour isoler le dispositif microélectronique fabriqué des autres dispositifs microélectroniques fabriqués en même temps sur le même substrat.

7. Procédé selon l'une quelconque des revendications précédentes, dans lequel le procédé comprend, avant l'empilement du second niveau, et après le déplacement du plot, une étape d'enrobage (112, 122) du premier niveau avec un matériau d'enrobage pour former une base sur laquelle le second niveau est ensuite empilé et pour immobiliser le plot électrique dans sa position de connexion.

8. Procédé selon l'une quelconque des revendications 1 à 6, dans lequel le procédé comprend, après le déplacement du plot et après l'empilement du second niveau, une étape d'enrobage du dispositif microélectronique avec un matériau d'enrobage pour immobiliser le plot électrique dans sa position de connexion.

9. Procédé selon l'une quelconque des revendications précédentes, dans lequel, après le déplacement du plot, le procédé comprend l'empilement (120) du second composant électrique au moins en partie au-dessus du plot électrique de manière à raccorder le plot électrique à un contact électrique ménagé en vis-à-vis sur une face extérieure du second composant électrique.

10. Procédé selon l'une quelconque des revendications précédentes, dans lequel la fabrication (102) du plot électrique s'effectue en même temps que la fabrication de pistes conductrices et/ou de plots conducteurs du premier niveau sur le substrat.

11. Procédé selon l'une quelconque des revendications précédentes, dans lequel le premier et/ou le second composants électriques est une puce microélectronique.

12. Procédé selon l'une quelconque des revendications précédentes, dans lequel la largeur et la longueur du plot électrique sont au moins cinq fois plus grandes que son épaisseur.

13. Dispositif microélectronique comportant :

- un substrat (4),
- au moins un premier et un second composants électriques (8, 10; 164) répartis, respectivement, dans des premier et second niveaux (12, 14 ; 162) empilés l'un au-dessus de l'autre sur le substrat,
- au moins un plot électrique (40) dont la largeur et la longueur sont supérieures à son épaisseur, par l'intermédiaire duquel les premier et second composants électriques sont électriquement reliés entre eux, ce plot électrique présentant une face supérieure,

**caractérisé en ce que** le dispositif microélectronique comporte également au moins un premier et un deuxième bras de longueurs différentes, chacun de ces bras reliant mécaniquement directement le plot électrique à un point d'ancrage fixe respectif sur le substrat.

14. Dispositif selon la revendication 13, dans lequel le dispositif microélectronique comporte un dépôt de matériau fusible ou thermocompressible pour réaliser le raccordement électrique entre le second composant électrique et le plot.

Fig. 1

Fig. 2

Fig. 3

Fig. 4

Fig. 5

Fig. 6

```
┌──────────┐
│    70    │
└──────────┘
      │
┌──────────┐
│    74    │
└──────────┘
      │
┌──────────┐
│    78    │
└──────────┘
      │
┌──────────┐
│    80    │
└──────────┘
      │
┌──────────┐
│    82    │
└──────────┘
      │
┌──────────┐
│    86    │
└──────────┘
      │
┌──────────┐
│    92    │
└──────────┘
      │
┌──────────┐
│    96    │
└──────────┘
      │
┌──────────┐
│    98    │
└──────────┘
      │
┌──────────┐
│   102    │
└──────────┘
      │
┌──────────┐
│   104    │
└──────────┘
      │
┌──────────┐
│   106    │
└──────────┘
      │
┌──────────┐
│   108    │
└──────────┘
      │
┌──────────┐
│   112    │
└──────────┘
      │
┌──────────┐
│   116    │
└──────────┘
      │
┌──────────┐
│   118    │
└──────────┘
      │
┌──────────┐
│   120    │
└──────────┘
      │
┌──────────┐
│   122    │
└──────────┘
      │
┌──────────┐
│   124    │
└──────────┘
      │
┌──────────┐
│   126    │
└──────────┘
```

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

Fig. 23

Fig. 24

Fig. 25

Fig. 26

Fig. 27

Fig. 28

Fig. 29

Fig. 30

Europäisches
Patentamt

European
Patent Office

Office européen
des brevets

# RAPPORT DE RECHERCHE EUROPEENNE

Numéro de la demande

EP 11 16 3545

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/294941 A1 (OH JIHOON [KR] ET AL) 3 décembre 2009 (2009-12-03) | 13,14 | INV. H01L21/98 H01L25/065 |
| A | * alinéa [0028] - alinéa [0059]; figures 1-9 * | 1-12 | |
| | ----- | | |
| X | US 6 627 990 B1 (SHIM IL KWON [SG] ET AL) 30 septembre 2003 (2003-09-30) | 13,14 | |
| A | * colonne 3, ligne 53 - colonne 4, ligne 59; figures 3-6 * | 1-12 | |
| | ----- | | |
| A | US 6 183 267 B1 (MARCUS ROBERT B [US] ET AL) 6 février 2001 (2001-02-06) * colonne 6, ligne 19 - colonne 10, ligne 16; figures 1,3-12 * | 1-14 | |
| | ----- | | |
| X | US 2002/171133 A1 (MOK SAMMY [US] ET AL) 21 novembre 2002 (2002-11-21) * alinéa [0187] - alinéa [0206]; figures 35-54 * | 1-14 | |
| | ----- | | DOMAINES TECHNIQUES RECHERCHES (IPC) |
| X | EUGENE M CHOW ET AL: "Pressure Contact Micro-Springs in Small Pitch Flip-Chip Packages", IEEE TRANSACTIONS ON COMPONENTS AND PACKAGING TECHNOLOGIES, IEEE SERVICE CENTER, PISCATAWAY, NJ, US, vol. 29, no. 4, 1 décembre 2006 (2006-12-01), pages 796-803, XP011151120, ISSN: 1521-3331, DOI: DOI:10.1109/TCAPT.2006.885959 * le document en entier * | 1-14 | H01L B81C G01R |
| A | US 2009/001486 A1 (HECK JOHN [US] ET AL) 1 janvier 2009 (2009-01-01) * alinéa [0012] - alinéa [0032]; figures 1-5 * | 1-14 | |
| | ----- | | |
| | -/-- | | |

Le présent rapport a été établi pour toutes les revendications

| Lieu de la recherche | Date d'achèvement de la recherche | Examinateur |
|---|---|---|
| Munich | 10 août 2011 | Gospodinova, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 11 16 3545

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (IPC) |
| A | BAGOLINI A ET AL: "A single metal layer MEMS self-assembling coplanar structure", JOURNAL OF MICROMECHANICS & MICROENGINEERING, INSTITUTE OF PHYSICS PUBLISHING, BRISTOL, GB, vol. 17, no. 5, 1 mai 2007 (2007-05-01), pages 945-948, XP020120090, ISSN: 0960-1317, DOI: DOI:10.1088/0960-1317/17/5/014 * le document en entier * | 1-14 | |
| A | US 2010/019362 A1 (GALERA MANOLITO [SG] ET AL) 28 janvier 2010 (2010-01-28) * alinéa [0012] - alinéa [0032]; figures 1-15 * | 1-14 | |
| A | US 5 475 318 A (MARCUS ROBERT B [US] ET AL) 12 décembre 1995 (1995-12-12) * colonne 2, ligne 49 - colonne 9, ligne 22; figures 1-12B * | 1-14 | |
| A | US 2008/242049 A1 (JUNG DENIS [DE] ET AL) 2 octobre 2008 (2008-10-02) * alinéa [0018] - alinéa [0041]; figures 1-11 * | 1-14 | DOMAINES TECHNIQUES RECHERCHES (IPC) |
| A | US 2008/217792 A1 (ONODERA MASANORI [JP] ET AL) 11 septembre 2008 (2008-09-11) * figures 3A-5,9 * | 1-14 | |

Le présent rapport a été établi pour toutes les revendications

| Lieu de la recherche | Date d'achèvement de la recherche | Examinateur |
|---|---|---|
| Munich | 10 août 2011 | Gospodinova, M |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

...........................................................................................
& : membre de la même famille, document correspondant

EPO FORM 1503 03.82 (P04C02)

**EP 2 381 472 A1**

**ANNEXE AU RAPPORT DE RECHERCHE EUROPEENNE
RELATIF A LA DEMANDE DE BREVET EUROPEEN NO.**

EP 11 16 3545

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-08-2011

| Document brevet cité au rapport de recherche | | Date de publication | Membre(s) de la famille de brevet(s) | Date de publication |
|---|---|---|---|---|
| US 2009294941 | A1 | 03-12-2009 | AUCUN | |
| US 6627990 | B1 | 30-09-2003 | SG 113495 A1 | 29-08-2005 |
| US 6183267 | B1 | 06-02-2001 | US 6484395 B1 | 26-11-2002 |
| US 2002171133 | A1 | 21-11-2002 | AUCUN | |
| US 2009001486 | A1 | 01-01-2009 | AUCUN | |
| US 2010019362 | A1 | 28-01-2010 | US 2011062570 A1 | 17-03-2011 |
| US 5475318 | A | 12-12-1995 | AUCUN | |
| US 2008242049 | A1 | 02-10-2008 | CN 101279712 A<br>DE 102008013116 A1 | 08-10-2008<br>09-10-2008 |
| US 2008217792 | A1 | 11-09-2008 | JP 2008218926 A | 18-09-2008 |

EPO FORM P0460

Pour tout renseignement concernant cette annexe : voir Journal Officiel de l'Office européen des brevets, No.12/82

21

**EP 2 381 472 A1**